# EUROPEAN PATENT APPLICATION

(11) **EP 4 451 459 A1**
(43) Date of publication of application: **23.10.2024**
(21) Application number: 22906170.0
(22) Date of filing: 17.11.2022
(51) Int. Cl.: H01P 1/36

(54) **ELECTRIC SHIELDING MAGNETIC TUNNEL JUNCTION SIGNAL ISOLATOR**

(30) Priority: 17.12.2021 CN 202111549648
(71) Applicant: MultiDimension Technology Co., Ltd., Jiangsu 215634 (CN)
(72) Inventor: DEAK, James Geza, Zhangjiagang, Jiangsu 215634 (CN); ZHOU, Zhimin, Zhangjiagang, Jiangsu 215634 (CN)
(74) Representative: HGF
(86) International application number: PCT/CN2022/132434
(87) International publication number: WO 2023/109418

(57) **Abstract**

Disclosed in the embodiments of the present invention is a magnetic Tunnel junction signal isolator with electric shielding layer. In the isolator, a coil is located between a magnetic shielding layer and an electric shielding layer; the electric shielding layer is located between the coil and a magnetoresistive sensor, the magnetoresistive sensor is composed of a plurality of magnetic tunnel junctions that are connected in a series-parallel way. The two ends of the coil are electrically connected to a circuit having a first reference ground used to send a signal; a signal is sent from the magnetoresistive sensor to a receiving circuit connected to a second reference ground. The magnetic shielding layer is electrically connected to the first reference ground in a single-point or multi-point mode, or it is completely electrically isolated from the first reference ground. The electric shielding layer may instead be electrically connected to the second reference ground in a single-point or multi-point mode, or it may be completely electrically isolated from the second reference ground. Or, the electric shielding layer and magnetic shielding layer are respectively electrically connected to any potential or potentials between the first reference ground and the second reference ground in a single-point or multi-point mode. The embodiments of the present invention, prevent the electric field from corrupting the magnetoresistive sensor signal, as such solving the problem of interference and damage caused to a magnetic tunnel junction in the magnetoresistive sensor by the coil.

## Description

### Technical Field

Embodiments of the present invention relate to the technical field of magnetic sensors, in particular, to a magnetic tunnel junction signal isolator with electric shielding layer.

### Background Technology

The magnetoresistive isolator connects the signal transmitting circuit at both ends of the coil and the signal receiving circuit at both ends of the magnetic sensor through the non-contact relationship between the magnetic field signal source and the magnetic sensor, thereby realizing the physical isolation of the signal transmitting circuit and the signal receiving circuit.

The existing patent discloses a magnetic digital signal coupler, which includes a coil and a magnetic sensor located below or above the coil. In order to prevent interference from an external magnetic field, a magnetic shielding layer is also arranged above or below the coil and the magnetic sensor. An insulating layer is used between the coil, the magnetic sensor and the magnetic shielding layer to achieve electrical isolation. However, this scheme only considers the magnetic field interaction between the coil and the magnetic sensor. In fact, the spiral coil itself has a first reference ground and a first voltage source or current source, so the coil has different first potential distributions along the current direction and generates an electric field distribution in the surrounding space. Moreover, the magnetic sensor itself has a second reference ground and a second voltage source or current source, so the magnetic sensor also has a certain second potential distribution.

Due to the unequal potential between the first reference ground and the second reference ground, in this case, there is a potential difference between the first potential and the second potential. This potential difference will generate an electric field at the position of the magnetic sensor, and this electric field will have a destructive effect on the magnetic sensor. For example, for a magnetic tunnel junction sensor, the electric field may break down the magnetic tunnel junction.

### Summary of the Invention

The embodiments of the present invention provide a magnetic tunnel junction signal isolator with electric shielding layer to solve the problem that the existing signal isolator based on the magnetic tunnel junction is easily destroyed by the electric field.

The embodiments of the present invention further provide magnetic tunnel junction signal isolators with electric shielding layer, including:
A magnetic shielding layer, a coil, an electric shielding layer and a magnetoresistive sensor. The coil is located between the magnetic shielding layer and the electric shielding layer. The electric shielding layer is located between the coil and the magnetoresistive sensor. The magnetoresistive sensor is composed of a plurality of magnetic tunnel junctions that are connected in a series-parallel way;
Signal transmitting circuit: the signal transmitting circuit is electrically connected to two ends of the coil, and has a first reference ground;
Signal receiving circuit: the signal receiving circuit is connected to the magnetoresistive sensor, and has a second reference ground;
The magnetic shielding layer is electrically connected to the first reference ground in a single-point or multi-point mode, or it is completely electrically isolated from the first reference ground. The electric shielding layer may instead be electrically connected to the second reference ground in a single-point or multi-point mode, or it may be completely electrically isolated from the second reference ground. Or, the electric shielding layer and magnetic shielding layer are respectively electrically connected to any potential or potentials between the first reference ground and the second reference ground in a single-point or multi-point mode.

Furthermore, the magnetoresistive sensors are connected by push arms and/or pull arms to form a push-pull bridge structure for measuring a magnetic field gradient or a magnetic field value. In this structure,
The push arm is composed of an interconnected array of push magnetoresistive sensor units. The array of push magnetoresistive sensor units is composed of push magnetoresistive sensor units connected in series and in parallel. The push magnetoresistive sensor unit is composed of a plurality of the magnetoresistive sensors connected in series and in parallel;
The pull arm is composed of an interconnected array of pull magnetoresistive sensor units. The array of pull magnetoresistive sensor units is composed of pull magnetoresistive sensor units connected in series and in parallel. The pull magnetoresistive sensor unit is composed of a plurality of the magnetoresistive sensors connected in series and in parallel;
The push-pull bridge structure includes any one of a push-pull half-bridge structure, a push-pull full-bridge structure, a push-pull quasi-bridge structure and a single-arm electric bridge structure.
Furthermore, the angle between the magnetic field sensitive direction of the push magnetoresistive sensor unit array and the reference horizontal direction is α. The angle between the magnetic field sensitive direction of the pull magnetoresistive sensor unit array and the reference horizontal direction is β;
The surface on one side of the coil has a first sub-region and a second sub-region. In the direction perpendicular to the coil, the push magnetoresistive sensor unit array is located in the first sub-region and the pull magnetoresistive sensor unit array is located in the second sub-region. When current flows through the first sub-region, magnetic field Bα is generated along the magnetic field sensitive direction of the push magnetoresistive sensor unit array. When current flows through the second sub-region, magnetic field Bβ is generated along the magnetic field sensitive direction of the pull magnetoresistive sensor unit array;
Bα and Bβ are equal in size. The direction of Bα is the same as the magnetic field sensitive direction of the push magnetoresistive sensor unit array, while the direction of Bβ is opposite to the magnetic field sensitive direction of the pull magnetoresistive sensor unit array. The range of α and β is 0-360°.

Furthermore, the magnetoresistive sensor is a linear or switched one. A plurality of magnetic tunnel junctions in the linear or switched magnetoresistive sensor are connected to form a two-port structure.

Furthermore, the magnetic tunnel junction signal isolator includes magnetic shielding pins and/or electric shielding pins. The magnetic shielding layer sets an electric potential through the magnetic shielding pins, and the electric shielding layer sets an electric potential through the electric shielding pins.

Furthermore, the signal transmitting circuit is connected to the coil in a passive or active manner.

Furthermore, the signal receiving circuit is connected to the magnetoresistive sensor in a passive or active manner.

Furthermore, during packaging, the dice containing the magnetic tunnel junction signal isolator are placed separately on a lead frame and then packaged with packaging materials; or,
During packaging, the dice containing the magnetic tunnel junction signal isolator and the signal transmitting circuit are placed on a lead frame and then packaged with packaging materials; or,
During packaging, the dice containing the magnetic tunnel junction signal isolator and signal receiving circuit are placed on a lead frame and then packaged with packaging materials;
During packaging, the pins of the signal transmitting circuit and the pins of the signal receiving circuit on the lead frame are respectively located on two opposite sides of the lead frame;
The packaging material is any one of polymer material, ceramic material, ferromagnetic metal and non-magnetic metal.

Further, it also includes: an electric shielding potential setting circuit and/or a magnetic shielding potential setting circuit;
The electric shielding potential setting circuit ensures that the measured potential difference is equal to the set potential difference by comparing the measured potential difference between the magnetoresistive sensor and the coil with the set potential difference, and adjusting the potential size of the electric shielding layer;
The magnetic shielding potential setting circuit ensures that the measured potential difference is equal to the set potential difference by comparing the measured potential difference between the magnetoresistive sensor and the coil with the set potential difference, and adjusting the potential size of the magnetic shielding layer.

Furthermore, the magnetic shielding layer, the coil, the magnetoresistive sensor and the electric shielding layer are isolated by insulating materials, and the insulating materials are Si₃N₄, Al₂O₃, photoresist, SiO₂ or polyimide.

Furthermore, the coil has a thickness ranging from 1 µm to 20 µm, a width ranging from 5 µm to 40 µm, and a spacing ranging from 10 µm to 100 µm. The magnetic shielding layer and the electric shielding layer have a thickness ranging from 1 µm to 20 µm.

Embodiments of the present invention provide a magnetic tunnel junction signal isolator with electric shielding layer. The coil is located between a magnetic shielding layer and an electric shielding layer, and the electric shielding layer is located between the coil and a magnetoresistive sensor. A non-magnetic electric shielding layer is added between the coil and the magnetoresistive sensor, which can shield the electric field generated by the common-mode voltage difference between the coil and a second reference ground and prevent the electric field from destroying the magnetic field signal of the magnetoresistive sensor. Thereby, the problem of interference and damage to magnetic tunnel junctions in magnetoresistive sensors caused by the coil is resolved.

### Description of the Drawings

In order to more clearly illustrate the technical solutions in the embodiments of the present invention or the prior art, the drawings required in the illustration of the embodiments or the prior art are briefly introduced below. Obviously, although the drawings described below are some specific embodiments of the present invention, for those skilled in the art, the drawings can be developed and extended to other structures and drawings in accordance with the device structure disclosed and prompted by the various embodiments of the present invention, and the basic concepts of driving method and manufacturing method. There is no doubt that these should fall within the scope of the claims of the present invention.
Fig. 1a is a schematic diagram of a magnetic tunnel junction signal isolator with electric shielding layer provided in embodiments of the present invention;
Fig. 1b is a schematic diagram of another magnetic tunnel junction signal isolator with electric shielding layer provided in embodiments of the present invention;
Fig. 1c is a schematic diagram of the third magnetic tunnel junction signal isolator with electric shielding layer provided in embodiments of the present invention;
Fig. 1d is a schematic diagram of the fourth magnetic tunnel junction signal isolator with electric shielding layer provided in embodiments of the present invention;
Fig. 2a is the distribution diagram of the first sub-region and the magnetic tunnel junction in the coil provided in embodiments of the present invention;
Fig. 2b is the distribution diagram of the second sub-region and the magnetic tunnel junction in the coil provided in embodiments of the present invention;
Fig. 2c shows the magnetic field orientation diagram of push magnetoresistive sensor units provided in embodiments of the present invention;
Fig. 2d shows the magnetic field orientation diagram of pull magnetoresistive sensor units provided in embodiments of the present invention;
Fig. 3a shows the signal-magnetic field conversion curve of a linear magnetoresistive sensor;
Fig. 3b shows the signal-magnetic field conversion curve of a switched magnetoresistive sensor;
Fig. 3c shows the magnetization direction, sensitive direction and magnetic field direction of the free layer of the linear push magnetoresistive sensor unit;
Fig. 3d shows the magnetization direction, sensitive direction and magnetic field direction of the free layer of the switched push magnetoresistive sensor unit;
Fig. 3e shows the magnetization direction, sensitive direction and magnetic field direction of the free layer of the linear pull magnetoresistive sensor unit;
Fig. 3f shows the magnetization direction, sensitive direction and magnetic field direction of the free layer of the switched pull magnetoresistive sensor unit;
Fig. 4 is a schematic diagram of a spiral coil;
Fig. 5a shows the circuit diagram of a push-pull full-bridge structure composed of a magnetoresistive sensor;
Fig. 5b shows the circuit diagram of a push-pull half-bridge structure composed of a magnetoresistive sensor;
Fig. 5c shows the circuit diagram of a push-pull quasi-bridge structure composed of a magnetoresistive sensor;
Fig. 5d shows the structural diagram of a single push arm and bridge arm composed of connected push magnetoresistive sensors;
Fig. 6 shows the two-dimensional electric field distribution diagram of isolator without electric shielding layer;
Fig. 7 shows the two-dimensional electric field distribution diagram of isolator with electric shielding layer;
Fig. 8 shows the potential distribution diagram of the isolator without/with a charged shielding layer corresponding to Fig. 6 and Fig. 7 at the magnetic tunnel junction;
Fig. 9 shows the distribution of electric field E of the isolator without/with a charged shielding layer corresponding to Fig. 6 and Fig. 7 at the magnetic tunnel junction;
Fig. 10 shows the distribution of electric field Ey of the isolator without/with a charged shielding layer corresponding to Fig. 6 and Fig. 7 at the magnetic tunnel junction;
Fig. 11 shows the distribution of electric field Ex potential distribution diagram of the isolator without/with a charged shielding layer corresponding to Fig. 6 and Fig. 7 at the magnetic tunnel junction;
Fig. 12 shows the lead frame of isolator with electric shielding layer;
Fig. 13 shows another lead frame of isolator with electric shielding layer;
Fig. 14 shows the third lead frame of isolator with electric shielding layer;
Fig. 15 shows the fourth lead frame of isolator with electric shielding layer;
Fig. 16 shows the external potential setting of the magnetic shielding layer and the electric shielding layer in isolator with magnetic shielding layer.

### Specific Implementation Methods

In order to make the purpose, technical solutions and advantages of the present invention clearer, the technical solutions of the present invention will be clearly and completely described through implementations with reference to the accompanying drawings in the embodiments of the present invention. Obviously, the described embodiments are some, rather than all, embodiments of the present invention. Based on the basic concepts disclosed and prompted by the embodiments of the present invention, all other embodiments obtained by those skilled in the art fall within the protection scope of the present invention.

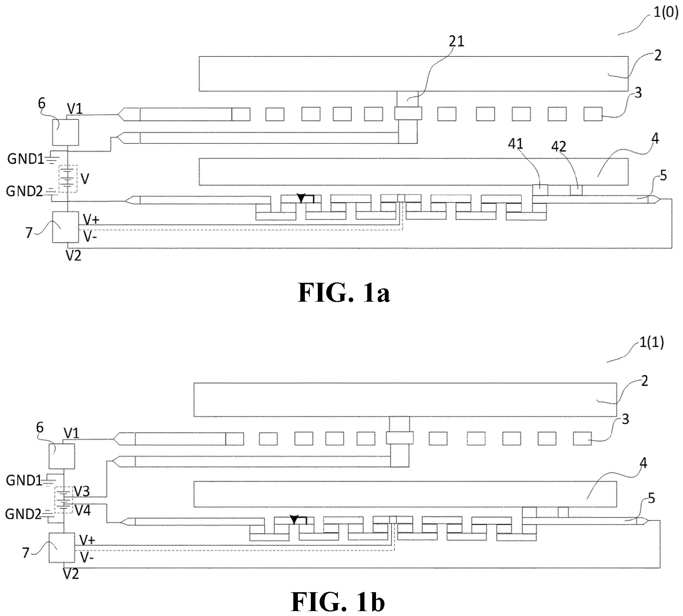

The contents shown in Fig. 1a to Fig. 1d are schematic diagrams of four magnetic tunnel junction signal isolators with electric shielding layer provided in embodiments of the present invention. The four magnetic tunnel junction signal isolators with electric shielding layer provided in this embodiment are marked as 1(0) to 1(3) in sequence. Specifically, the magnetic tunnel junction signal isolator with electric shielding layer includes: magnetic shielding layer 2, coil 3, electric shielding layer 4 and magnetoresistive sensor 5. Coil 3 is located between magnetic shielding layer 2 and electric shielding layer 4. Electric shielding layer 4 is located between coil 3 and magnetoresistive sensor 5. Magnetoresistive sensor 5 is composed of multiple magnetic tunnel junctions connected in series and parallel. Signal transmitting circuit 6: signal transmitting circuit 6 is electrically connected to both ends of coil 3, and has a first reference ground GND1. Signal receiving circuit 7: signal receiving circuit 7 is connected to the magnetoresistive sensor 5, and has a second reference ground GND. Magnetic shielding layer 2 is electrically connected to the first reference ground GND1 in a single-point or multi-point mode, or it is completely electrically isolated from the first reference ground. Electric shielding layer 4 may instead be electrically connected to the second reference ground GND2 in a single-point or multi-point mode, or it may be completely electrically isolated from the second reference ground. Or electric shielding layer 4 and magnetic shielding layer 2 are respectively electrically connected to any potential between the first reference ground GND1 and the second reference ground GND2 in a single-point or multi-point mode.

In this embodiment, both ends of the coil 3 are electrically connected to the signal transmitting circuit 6, and both ends of the magnetoresistive sensor 5 are electrically connected to the signal receiving circuit 7. The potential at one end of the coil 3 is V1, and the potential at one end of the magnetoresistive sensor 5 is V2. There are many different connection methods between the magnetic shielding layer 2 and the electric shielding layer 4, so as to form a variety of different magnetic tunnel junction signal isolators with electric shielding layer. Fig. 1a to Fig. 1d only show four types of magnetic tunnel junction signal isolators with electric shielding layer. Depending on the different connection methods between the magnetic shielding layer 2 and the electric shielding layer 4, there can be many types of magnetic tunnel junction signal isolators with electric shielding layer, not limited to those shown in Fig. 1a to Fig. 1d.

Refer to the magnetic tunnel junction signal isolator 1 (0) with electric shielding layer shown in Fig. 1a. In this isolator, the magnetic shielding layer 2 is electrically connected to the first reference ground GND1 of the signal transmitting circuit 6 through a single point 21, and the electric shielding layer 4 is electrically connected to the second reference ground GND2 of the signal receiving circuit 7 through multiple points 41 and 42. One end of the coil 3 is electrically connected to the potential V1 of the signal transmitting circuit 6, and the other end is electrically connected to the first reference ground GND1. One end of the magnetoresistive sensor 5 is electrically connected to the potential V2 of the signal receiving circuit 7, and the other end is electrically connected to the second reference ground GND2.

Refer to the magnetic tunnel junction signal isolator 1 (1) with electric shielding layer shown in Fig. 1b. In this isolator, the magnetic shielding layer 2 is electrically connected to the potential V3 in a single-point mode, and electric shielding layer 4 is connected to the potential V4 in a multi-point mode. Potential V3 and V4 are potentials between the first reference ground GND 1 of signal transmitting circuit 6 and the second reference ground GND 2 of signal receiving circuit 7. One end of the coil 3 is electrically connected to the potential V1 of the signal transmitting circuit 6, and the other end is electrically connected to potential V3. One end of the magnetoresistive sensor 5 is electrically connected to the potential V2 of the signal receiving circuit 7, and the other end is electrically connected to potential V4.

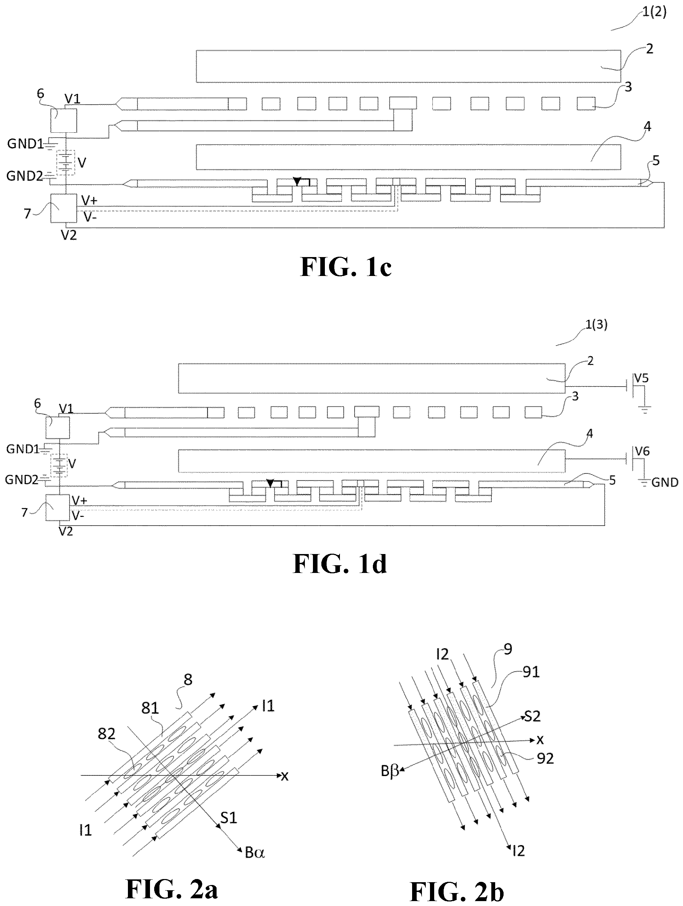

Refer to the magnetic tunnel junction signal isolator 1(2) with electric shielding layer shown in Fig. 1c. In this isolator, the magnetic shielding layer 2 is at a floating potential, and the electric shielding layer 4 is also at a floating potential. At this time, the magnetic shielding layer 2 is completely electrically isolated from the first reference ground GND1, and the electric shielding layer 4 is completely electrically isolated from the second reference ground GND2. One end of the coil 3 is electrically connected to the potential V1 of the signal transmitting circuit 6, and the other end is electrically connected to the first reference ground GND1. One end of the magnetoresistive sensor 5 is electrically connected to the potential V2 of the signal receiving circuit 7, and the other end is electrically connected to the second reference ground GND2.

The magnetic tunnel junction signal isolator with optional electric shielding layer includes magnetic shielding pins and/or electric shielding pins. The magnetic shielding layer 2 sets an electric potential through the magnetic shielding pins, and the electric shielding layer 4 sets an electric potential through the electric shielding pins. Specifically, the user independently sets the potential for the magnetic shielding layer 2 through its magnetic shielding pins, and/or the user independently sets the potential for the electric shielding layer 4 through its electric shielding pins. Refer to the electrically shielded magnetic tunnel junction signal isolator 1(3) with electric shielding layer shown in Fig. 1d. In this isolator, the magnetic shielding layer 2 is electrically connected to an external potential V5 set by a user, and the electric shielding layer 4 is electrically connected to an external potential V6 set by a user. For example, during packaging, the magnetic shielding layer 2 and the electric shielding layer 4 can also be individually led out with pins, and the pins can be set to any potential to facilitate users to directly connect to an external potential. One end of the coil 3 is electrically connected to the potential V1 of the signal transmitting circuit 6, and the other end is electrically connected to the first reference ground GND1. One end of the magnetoresistive sensor 5 is electrically connected to the potential V2 of the signal receiving circuit 7, and the other end is electrically connected to the second reference ground GND2.

Optional magnetic shielding layer 2, the coil 3, the magnetoresistive sensor 5 and the electric shielding layer 4 are isolated by insulating materials, and the insulating materials are Si₃N₄, Al₂O₃, photoresist, SiO₂ or polyimide. Two adjacent structures are isolated by an insulating layer. The magnetic shielding layer 2 and the coil 3 are isolated by an insulating layer. The coil 3 and the electric shielding layer 4 are isolated by an insulating layer. The magnetoresistive sensor 5 and the electric shielding layer 4 are isolated by an insulating layer. The optional insulating layer may be made of, but not limited to, Si₃N₄, Al₂O₃, photoresist, SiO₂ or polyimide. The coil 3 may be a spiral coil, and the magnetoresistive sensor 5 may be a linear magnetoresistive sensor or a switched magnetoresistive sensor.

The optional magnetic shielding layer 2 is made of high permeability ferromagnetic alloy. For example, the high permeability ferromagnetic alloy can be, but not limited to, NiFe, CoFeSiB, CoZrNb, CoFeB, FeSiB or FeSiBNbCu. Any high permeability ferromagnetic alloy suitable for the present invention falls within the protection scope of the present invention.

The optional coil 3 and the electric shielding layer 4 can be made of high conductivity metal materials. For example, the high conductivity metal materials can be, but not limited to, Cu, Ti, Au, Ta, Al or Pt. Any high conductivity metal material suitable for the present invention falls within the protection scope of the present invention.

The coil 3 has a thickness ranging from 1 µm to 20 µm, a width ranging from 5 µm to 40 µm, and a spacing ranging from 10 µm to 100 µm. The magnetic shielding layer 2 and the electric shielding layer 4 have a thickness ranging from 1 µm to 20 µm. In this embodiment, the thickness of the coil 3 is greater than or equal to 1 µm and less than or equal to 20 µm. The width of the coil 3 is greater than or equal to 5 µm and less than or equal to 40 µm. The spacing of the coil 3 is greater than or equal to 10 µm and less than or equal to 100 µm. The thickness of the magnetic shielding layer 2 is greater than or equal to 1 µm and less than or equal to 20 µm. The thickness of the electric shielding layer 4 is greater than or equal to 1 µm and less than or equal to 20 µm.

The optional magnetoresistive sensor 5 is a linear or switched one. A plurality of magnetic tunnel junctions in the linear or switched magnetoresistive sensor are connected to form a two-port structure. The linear or switched magnetoresistive sensor has a two-terminal structure formed by an interconnected array of magnetoresistive sensors, in which the magnetoresistive sensors in the array have the same magnetic field sensitive direction.

Embodiments of the present invention provide a magnetic tunnel junction signal isolator with electric shielding layer. The coil is located between a magnetic shielding layer and an electric shielding layer, and the electric shielding layer is located between the coil and a magnetoresistive sensor. A non-magnetic electric shielding layer is added between the coil and the magnetoresistive sensor, which can shield the electric field generated by the common-mode voltage difference between the coil and a second reference ground and prevent the electric field from destroying the magnetic field signal of the magnetoresistive sensor. Thereby, the problem of interference and damage to magnetic tunnel junctions in magnetoresistive sensors caused by the coil is resolved.

The optional magnetoresistive sensors are connected by push arms and/or pull arms to form a push-pull bridge structure for measuring the magnetic field gradient or magnetic field value. In this structure, the push arm is composed of an interconnected array of push magnetoresistive sensor units. The array of push magnetoresistive sensor units is composed of push magnetoresistive sensor units connected in series and in parallel. The push magnetoresistive sensor unit is composed of a plurality of magnetoresistive sensors connected in series and in parallel. The pull arm is composed of an interconnected array of pull magnetoresistive sensor units. The array of pull magnetoresistive sensor units is composed of pull magnetoresistive sensor units connected in series and in parallel. The pull magnetoresistive sensor unit is composed of a plurality of magnetoresistive sensors connected in series and in parallel. The push-pull bridge structure includes any one of a push-pull half-bridge structure, a push-pull full-bridge structure, a push-pull quasi-bridge structure and a single-arm bridge structure.

The angle between the magnetic field sensitive direction of the optional push magnetoresistive sensor unit array and the reference horizontal direction is α. The angle between the magnetic field sensitive direction of the pull magnetoresistive sensor unit array and the reference horizontal direction is β. The surface on one side of the coil has a first sub-region and a second sub-region. In the direction perpendicular to the coil, the push magnetoresistive sensor unit array is located in the first sub-region, and the pull magnetoresistive sensor unit array is located in the second sub-region. When current flows through the first sub-region, magnetic field Bα is generated along the magnetic field sensitive direction of the push magnetoresistive sensor unit array. When current flows through the second sub-region, magnetic field Bβ is generated along the magnetic field sensitive direction of the pull magnetoresistive sensor unit array. Bα and Bβ are equal in size. The direction of Bα is the same as the magnetic field sensitive direction of the push magnetoresistive sensor unit array, while the direction of Bβ is opposite to the magnetic field sensitive direction of the pull magnetoresistive sensor unit array. The range of α and β is 0-360°.

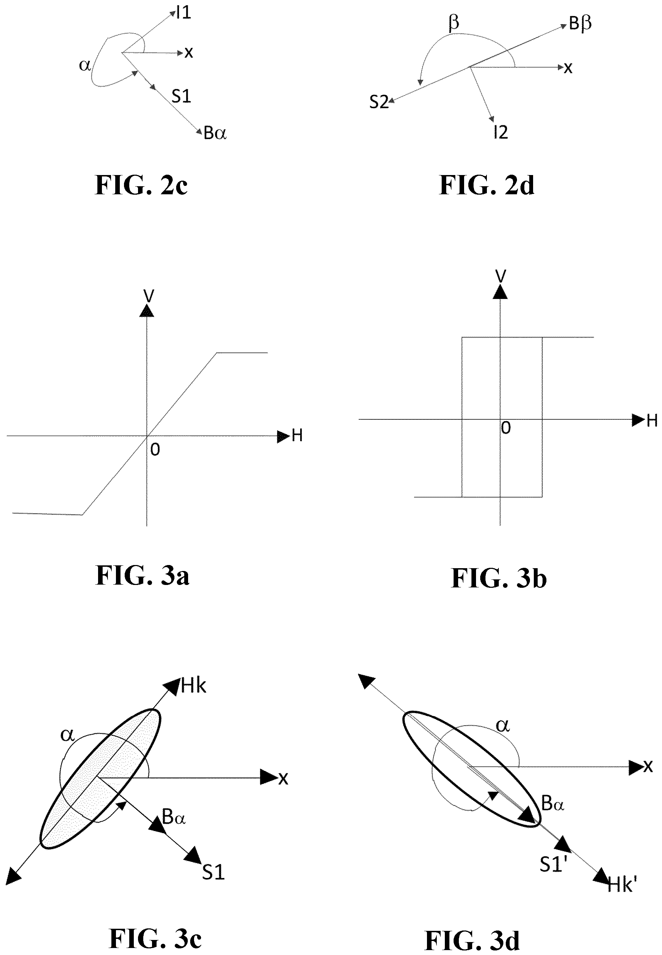

The contents shown in Fig. 2a to Fig. 2d are distribution diagrams of coils and magnetic tunnel junctions provided in embodiments of the present invention. The contents shown in Fig.2aare the distribution diagram of the first sub-region and the magnetic tunnel junction in the coil provided in embodiments of the present invention. The contents shown in Fig. 2b are the distribution diagram of the second sub-region and the magnetic tunnel junction in the coil provided in embodiments of the present invention. The contents shown in Fig.2c are the magnetic field orientation diagram of the push magnetoresistive sensor unit provided in embodiments of the present invention. The contents shown in Fig. 2d are the magnetic field orientation diagram of the pull magnetoresistive sensor unit provided in embodiments of the present invention. The coil includes two sub-regions. One of the sub-regions is the first sub-region 8 which is shown in Fig. 2a and includes a plurality of first conductive wires 81, and the other one is the second sub-region 9 which is shown in Fig. 2b and includes a plurality of second conductive wires 91. The first sub-region 8 includes N straight conductive wires arranged in parallel and equidistantly, in which N is an integer greater than or equal to 3. The second sub-region 9 includes N straight conductive wires arranged in parallel and equidistantly, in which N is an integer greater than or equal to 3.

In this embodiment, the magnetoresistive sensors composed of a plurality of magnetic tunnel structures are connected by push arms and/or pull arms to form a push-pull bridge structure. In this structure, the push arm in the push-pull bridge structure is composed of push magnetoresistive sensing units which are shown in Fig. 2 a and connected in series and in parallel to form a push magnetoresistive sensing unit array 82. The push magnetoresistive sensing unit is composed of a plurality of magnetoresistive sensors connected in series and in parallel. The pull arm in the push-pull bridge structure is composed of pull magnetoresistive sensing units which are shown in Fig. 2b and connected in series and in parallel to form a pull magnetoresistive sensing unit array 92. The pull magnetoresistive sensing unit is composed of a plurality of magnetoresistive sensors connected in series and in parallel.

The push magnetoresistive sensing unit array 82 is located above or below the first sub-region 8, and the pull magnetoresistive sensing unit array 92 is located above or below the second sub-region 9. For any push magnetoresistive sensing unit in Fig. 2a, its magnetic field sensitive direction S1 is in the α direction. The magnetic field generated along the magnetic field sensitive direction when the current I1 flows through the first sub-region 8 is Bα, where the magnetic field sensitive direction is actually the angle with the reference horizontal direction x. For any pull magnetoresistive sensing unit in Fig. 2b, its magnetic field sensitive direction S2 is in the β direction. The magnetic field generated along the magnetic field sensitive direction when the current I2 flows through the second sub-region 9 is Bβ, where the magnetic field sensitive direction is actually the angle with the reference horizontal direction x. Bα and Bβ are equal in size. The direction of Bα is the same as its corresponding magnetic field sensitive direction α, while the direction of Bβ is opposite to its corresponding magnetic field sensitive direction β. The range of α and β is 0°-360°, and α and β can be the same or different.

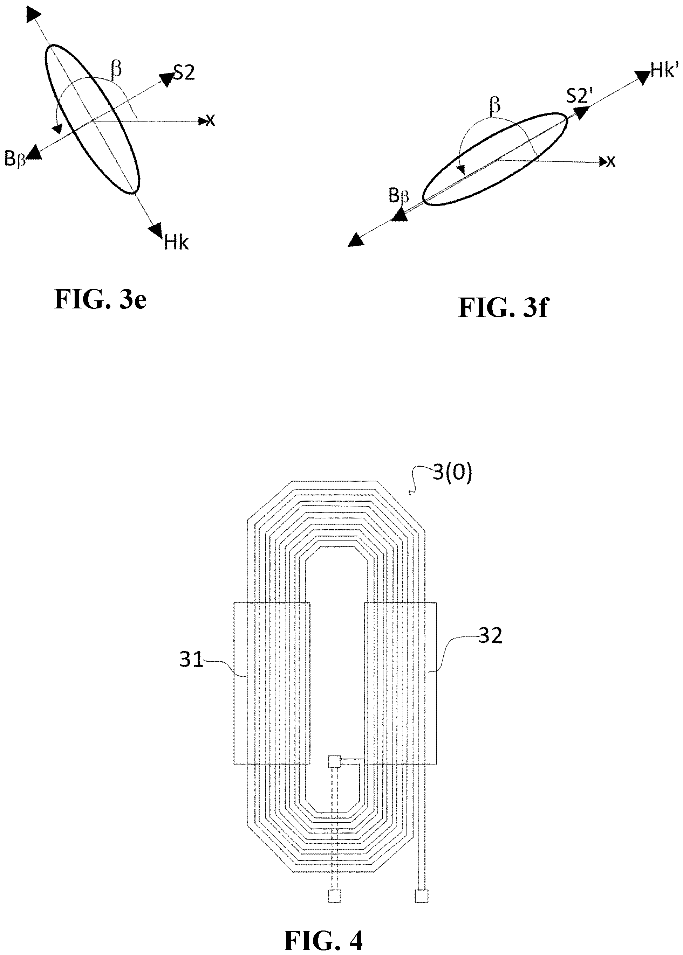

The magnetoresistive sensors can be of two types: linear magnetoresistive sensor and switched magnetoresistive sensors, as shown in Fig. 3a to Fig. 3f. Fig.3a is a signal-magnetic field characteristic curve of a linear magnetoresistive sensor, in which the magnetic field and the signal are in a linear relationship. Fig. 3b is a signal-magnetic field characteristic curve of a switched magnetoresistive sensor, in which the magnetic field and the signal are in a rectangular hysteresis relationship. In this way, the sensor can have a latching function and can remember the polarity and direction of the previous magnetic field signal. Fig. 3c and Fig.3e show the magnetization direction and sensitive direction of the free layer of the linear push magnetoresistive sensing unit and the linear pull magnetoresistive sensing unit, as well as the magnetic field direction of external magnetic field. The magnetization direction Hk of the free layer is perpendicular to the sensitive directions S2 and S1. Fig 3d and Fig. 3f show the magnetization direction and sensitive direction of the free layer of the switched push magnetoresistive sensing unit and the switched pull magnetoresistive sensing unit, as well as the magnetic field direction of external magnetic field. The magnetization direction Hk' of the free layer is parallel to the sensitive directions S1' and S2'. It can be seen that the difference between the linear and switched magnetoresistive sensors lies in the variation characteristics, with the change of magnetic field, of the hysteresis loop in the free layer caused by difference in the orientation of the free layer, while the orientation of the sensitive direction remains unchanged.

Several examples of α and β are given below.

Taking α=0, β=0 as an example, if the directions of Bα and Bβ are required to be opposite, then the corresponding push magnetoresistive sensing unit and pull magnetoresistive sensing unit are ones with the same orientation, and the first sub-region 8 and the second sub-region 9 are required to have opposite magnetic field directions. The contents shown in Fig. 4 is the schematic diagram of a spiral coil. Based on the spiral coil 3 (0), the push magnetoresistive sensor unit and the pull magnetoresistive sensor unit have the same magnetic field sensitive direction. The first sub-region 31 and the second sub-region 32 of the spiral coil have opposite current directions. The push magnetoresistive sensor unit array is located above or below the first sub-region 31, and the pull magnetoresistive sensor unit array is located above or below the second sub-region 32.

Taking α=0, β=180 as an example, if the magnetic field directions of Bα and Bβ are required to be the same, then the corresponding push magnetoresistive sensing unit and pull magnetoresistive sensing unit are ones with opposite orientations. For example, the two sensing units are reversed 180° from each other. The first sub-region 8 and the second sub-region 9 have the same magnetic field direction and can be located in the same area of the coil.

The sensitive direction of the magnetoresistive sensor can be written by laser magnetic field annealing to achieve a 180° reversal of α and β or other numerical values.

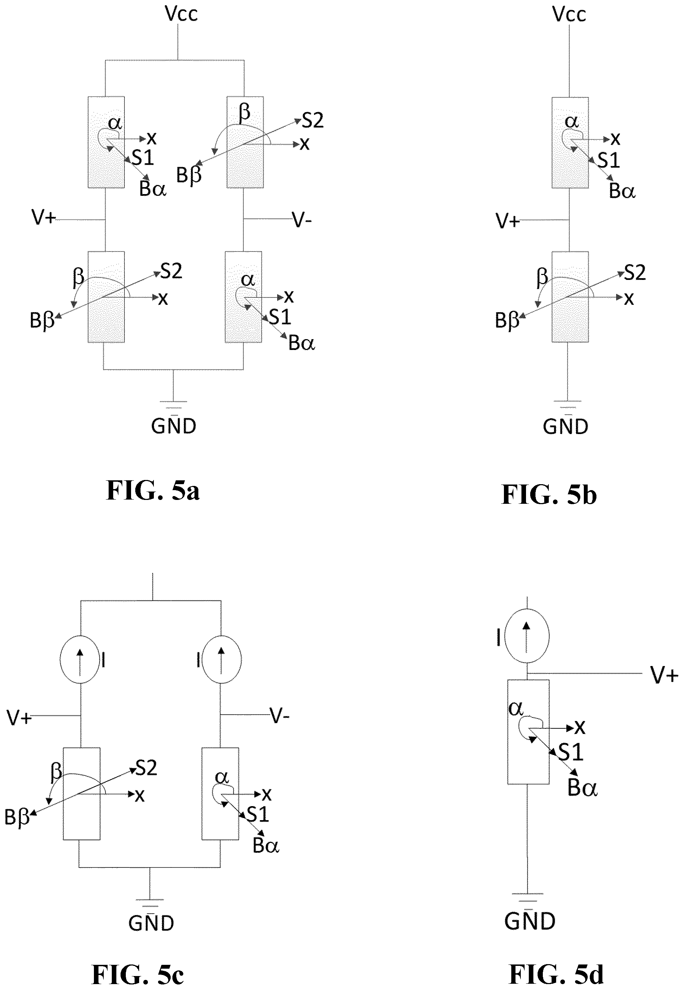

The contents shown in Fig. 5a to Fig. 5d are structural diagrams of magnetoresistive sensors based on magnetic tunnel junctions. The magnetoresistive sensor in Fig. 5a is connected by push arms and pull arms to form a push-pull full-bridge structure. The magnetoresistive sensor in Fig. 5b is connected by push arms and pull arms to form a push-pull half-bridge structure. The magnetoresistive sensor in Fig. 5c is connected by push arms and pull arms to form a push-pull quasi-bridge structure. The push-pull quasi-bridge structure includes two identical current sources, a pull arm and a push arm. The two current sources are respectively connected to the pull arm and the push arm to form a push-pull quasi-bridge structure. The push magnetoresistive sensor in Fig.5d is connected to form a single push-arm bridge structure.

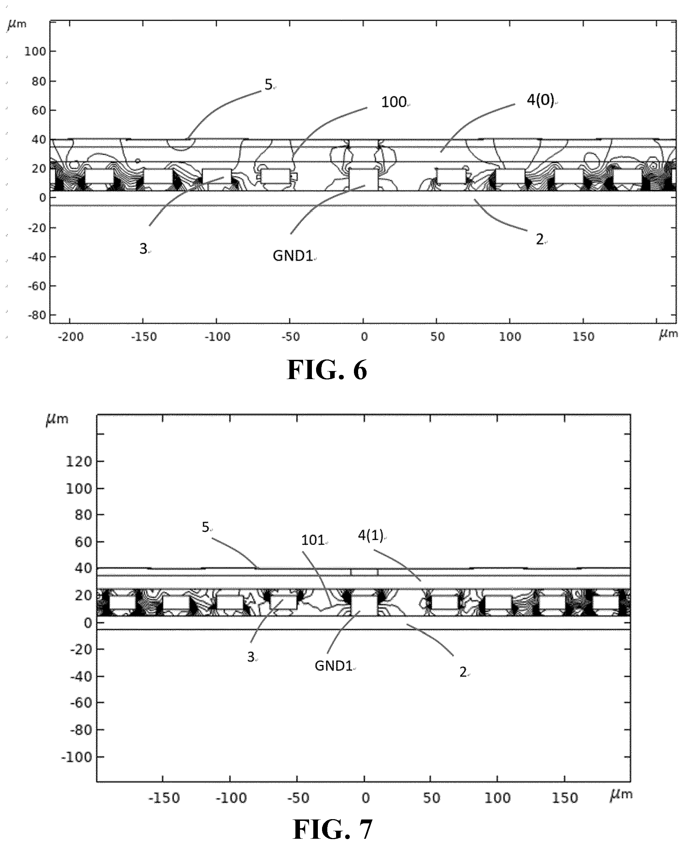

The contents shown in Fig. 6 is the two-dimensional electric field distribution diagram of isolator without electric shielding layer. In this diagram, 2 is a magnetic shielding layer.3 is the cross section of coil. GND1 is the first reference ground. 4(0) is defined as air material. 5 is the location of the magnetoresistive sensor composed of magnetic tunnel junctions. 100 is a power line.

The contents shown in Fig. 7 is the two-dimensional electric field distribution diagram of isolator with electric shielding layer. In this diagram, 2 is a magnetic shielding layer.3 is the cross section of coil. GND1 is the first reference ground. 4(1) is defined as air material. 5 is the location of the magnetoresistive sensor composed of magnetic tunnel junctions. 101 is a power line.

Comparing Fig. 6 and Fig. 7, it can be seen that when the electric shielding material 4 (1) is placed, the power lines are obviously concentrated below the electric shielding layer 4 (1).

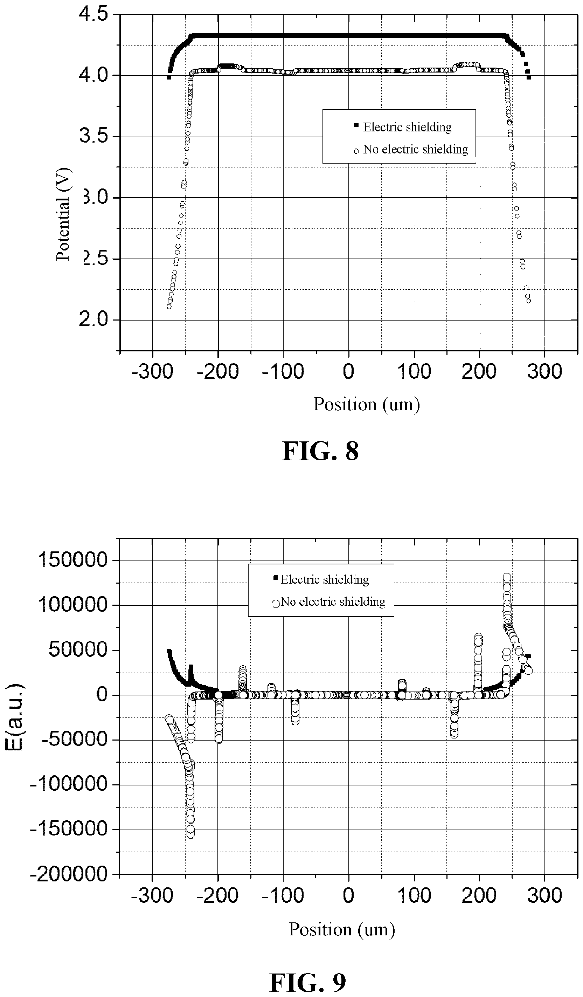

Fig. 8 shows the potential distribution diagram of the isolator without/with a charged shielding layer corresponding to Fig. 6 and Fig. 7 at the magnetic tunnel junction. As shown in Fig. 8, it can be seen that the electric potential of the isolator with an electric shielding layer increases at the position of magnetic tunnel. The reason is that the electric field inside the electric shielding layer itself is 0, which is equivalent to reducing the length of power line, thereby increasing the electric potential.

Fig. 9 shows the distribution of electric field E of the isolator without/with a charged shielding layer corresponding to Fig. 6 and Fig. 7 at the magnetic tunnel junction. As shown in Fig. 9, it can be seen that, in the absence of an electric shielding layer, the electric field strength E of the isolator has many high values at the location of the magnetoresistive sensor composed of magnetic tunnel junctions. However, in the presence of an electric shielding layer, the electric field strength E of the isolator is significantly reduced at the location of the magnetoresistive sensor composed of magnetic tunnel junctions, and the area is flat.

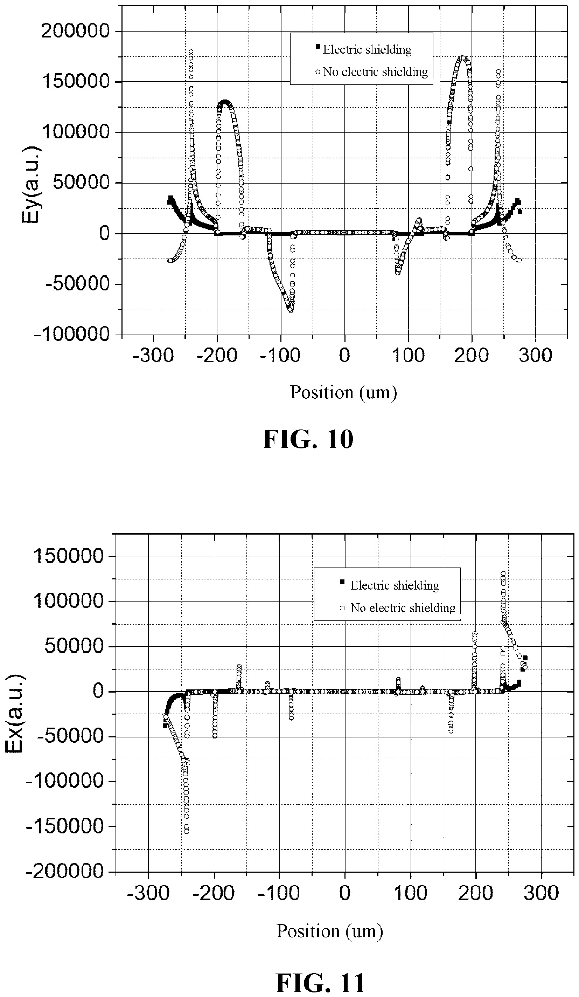

Fig. 10 shows the distribution of electric field Ey of the isolator without/with a charged shielding layer corresponding to Fig. 6 and Fig. 7 at the magnetic tunnel junction. As shown in Fig. 10, it can be seen that, in the absence of an electric shielding layer, the electric field strength E of the isolator oscillates between positive and negative values at the location of the magnetoresistive sensor composed of magnetic tunnel junctions. However, in the presence of an electric shielding layer, the electric field strength E of the isolator is significantly reduced at the location of the magnetoresistive sensor composed of magnetic tunnel junctions, and the area is flat. Since Ey mainly corresponds to the current direction of the magnetic tunnel junction, which is also the direction most likely to cause breakdown, the addition of the magnetic shielding layer greatly reduces the possibility of breakdown of the magnetic tunnel junction.

Fig. 11 shows the distribution of electric field Ex potential distribution diagram of the isolator without/with a charged shielding layer corresponding to Fig. 6 and Fig. 7 at the magnetic tunnel junction. As shown in Fig. 11, it can be seen that, in the absence of an electric shielding layer, the electric field strength E of the isolator oscillates between positive and negative values at the location of the magnetoresistive sensor composed of magnetic tunnel junctions. However, after adding the electric shielding layer, at the location of the magnetoresistive sensor formed by the magnetic tunnel structure, the electric field strength E of the isolator is significantly reduced at the location of the magnetoresistive sensor composed of magnetic tunnel junctions, and the area is flat.

The optional signal transmitting circuit is connected to the coil in a passive or active manner; the signal receiving circuit is connected to the magnetoresistive sensor in a passive or active manner. The optional coil is a spiral coil, and the magnetoresistive sensor is a linear magnetoresistive sensor.

During optional packaging, the dice containing the magnetic tunnel junction signal isolator are placed separately on the lead frame and then packaged with packaging materials; or, during packaging, the dice containing the magnetic tunnel junction signal isolator and the signal transmitting circuit are placed on the lead frame and then packaged with packaging materials; or, during packaging, the dice containing the magnetic tunnel junction signal isolator and the signal receiving circuit are placed on the lead frame and then packaged with packaging materials; during packaging, the pins of the signal transmitting circuit and the pins of the signal receiving circuit on the lead frame are respectively located on opposite sides of the lead frame; the packaging material is any one of a polymer material, a ceramic material, a ferromagnetic metal and a non-magnetic metal.

If the magnetic tunnel junction signal isolator with electric shielding layer is a passive method, its die can be placed on a lead frame separately for packaging. Alternatively, the die of magnetic tunnel junction signal isolator with electric shielding layer and the ASIC die of signal receiving circuit are placed together on a lead frame for packaging. Alternatively, the die of magnetic tunnel junction signal isolator with electric shielding layer and the ASIC die of signal transmitting circuit are placed together on a lead frame for packaging. Alternatively, the die of magnetic tunnel junction signal isolator with electric shielding layer, the ASIC die of signal transmitting circuit and the ASIC die of signal receiving circuit are placed together on a lead frame for packaging.

The optional magnetic tunnel junction signal isolator also includes: an electric shielding potential setting circuit and/or a magnetic shielding potential setting circuit; the electric shielding potential setting circuit ensures that the measured potential difference is equal to the set potential difference by comparing the measured potential difference between the magnetoresistive sensor and the coil with the set potential difference, and adjusting the potential size of the electric shielding layer; the magnetic shielding potential setting circuit ensures that the measured potential difference is equal to the set potential difference by comparing the measured potential difference between the magnetoresistive sensor and the coil with the set potential difference, and adjusting the potential size of the magnetic shielding layer.

The electric shielding potential setting circuit calculates the measured potential difference between the magnetoresistive sensor and the coil, and also pre-stores the set potential difference between the magnetoresistive sensor and the coil, and then compares the measured potential difference with the set potential difference. Then, the electric shielding potential setting circuit adjusts the magnitude of the electric shielding layer potential so that the measured potential difference is equal to the set potential difference.

The magnetic shielding potential setting circuit calculates the measured potential difference between the magnetoresistive sensor and the coil, and also pre-stores the set potential difference between the magnetoresistive sensor and the coil, and then compares the measured potential difference with the set potential difference. Then, the magnetic shielding potential setting circuit adjusts the magnitude of the magnetic shielding layer potential so that the measured potential difference is equal to the set potential difference.

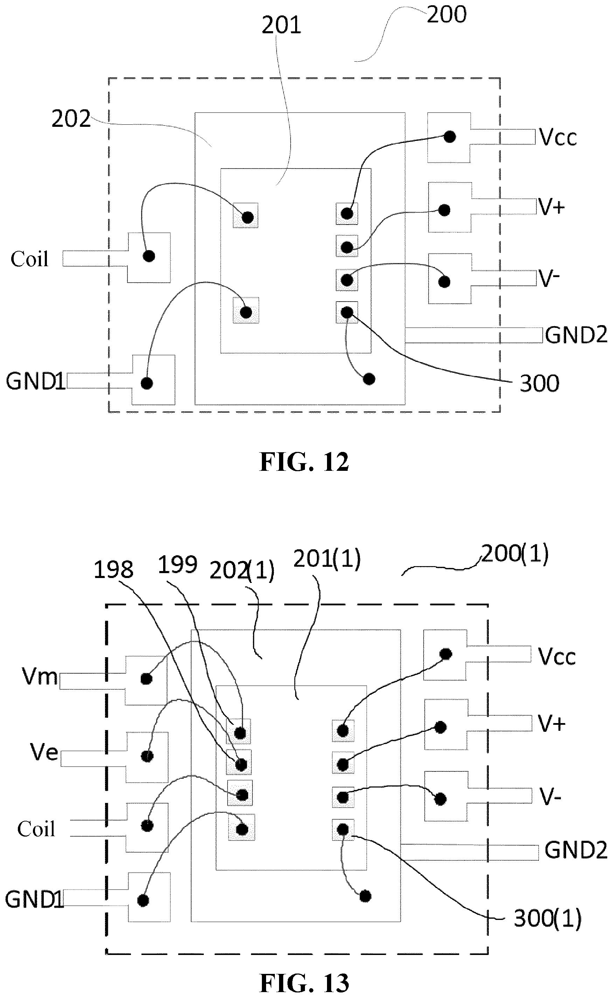

Fig. 12 shows the lead frame of an isolator with electric shielding layer. As shown in Fig. 12, the lead frame 200 includes an isolator die 201 with electric shielding layer, which is placed on lead frame 202. The pins of the lead frame 202 include a coil pin, a GND1 pin, a power supply Vcc pin of the magnetic tunnel junction sensor, a GND2 pin, and output signal terminals V+ and V-. The ground 300 of the magnetic tunnel junction sensor of the isolator die 201 with an electric shielding layer is wire-bonded to the lead frame pin GND2 of the lead frame 202.

Fig. 13 shows another lead frame of isolator with electric shielding layer. As shown in Fig. 13, lead frame 200 (1) includes an isolator die 201 (1) with an electrical shielding layer, which is placed on lead frame 202 (1). The isolator die 201 (1) with an electric shielding layer includes a die electric shielding layer pin 198 and a die magnetic shielding layer pin 199. The die electric shielding layer pin 198 is wire-bonded to the lead frame pin Ve, and the die magnetic shielding layer pin 199 is wire-bonded to the lead frame pin Vm. The user can set the potential of the electric shielding layer through pin Ve and the potential of the magnetic shielding layer through pin Vm. The ground 300 (1) of the magnetic tunnel junction sensor of the isolator die 201 (1) with an electric shield is wire-bonded to the lead frame pin GND2 of the lead frame 202 (1).

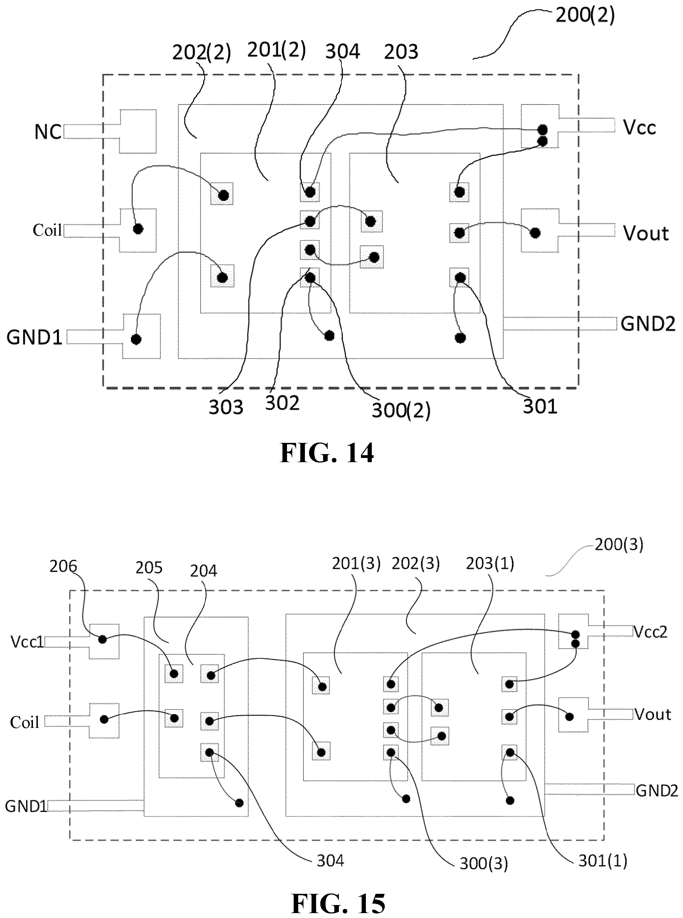

Fig. 14 shows the third lead frame of isolator with electric shielding layer. As shown in FIG. 14, the lead frame 200 (2) includes an isolator die 201 (2) with an electric shielding layer and a signal receiving circuit ASIC die 203. The two dice are placed together on the lead frame 202 (2). In this lead frame, die ground pin 300 (2) of the isolator die 201 (2) with an electric shielding layer is wired to the lead frame 202 (2), and the die ground pin 301 of the signal receiving circuit ASIC die 203 is wired to the lead frame 202 (2). The die signal output pins 303 and 304 of the isolator die 201 (2) with an electric shielding layer are wired to the input end of the signal receiving circuit ASIC die 203, and the signal receiving circuit ASIC die 203 and the isolator die 201 (2) with an electric shielding layer have the same power supply Vcc.

Fig. 15 shows the fourth lead frame of isolator with electric shielding layer. As shown in Fig. 15, the lead frame 200 (3) includes an isolator die 201 (3) with an electric shielding layer, a signal receiving circuit ASIC die 203 (1) and a signal transmitting circuit ASIC die 204. In this lead frame, 201 (3) and 203 (1) are placed together on a lead frame 202 (3), and 204 is placed on a lead frame 205. 202 (3) and 205 are electrically insulated. The die ground pin 304 of the signal transmitting circuit ASIC die 204 is wired to the lead frame 205 and then connected to the pin GND1 of the lead frame 200 (3); the power pin 206 of the signal transmitting circuit ASIC die 204 is electrically connected to the pin Vcc1 of the lead frame 200 (3). The die ground pin 300 (3) of the isolator die 201 (3) with an electric shielding layer and the die ground pin 301 (1) of the signal receiving circuit ASIC die 203 (1) are both wired to the lead frame 202 (3).

In addition, the pins corresponding to the signal transmitting circuit and the pins corresponding to the signal receiving circuit on the lead frame are respectively located on opposite sides of the lead frame, namely the left and right sides in the figure, to avoid mutual interference.

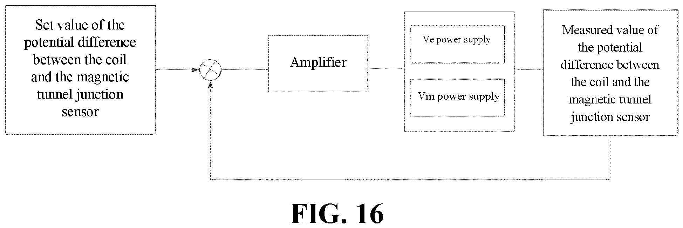

Fig. 16 shows the external potential setting of the magnetic shielding layer and the electric shielding layer in isolator with magnetic shielding layer. As shown in Fig. 16, a closed-loop control is implemented to keep the isolator within a reasonable operating range. Preset the set potential difference between the coil and the magnetic tunnel junction sensor, then calculate the actual measured potential difference between the coil and the magnetic tunnel junction sensor, and then compare the set potential difference with the measured potential difference. Control the method circuit including an amplifier according to the comparison result to adjust the potential Vm of the magnetic shielding layer pin or the potential Ve of the electric shielding layer pin, and finally ensure that the set potential difference between the coil and the magnetic tunnel junction sensor is equal to the actual measured potential difference.

It should be noted that, the above descriptions are merely the preferred embodiments and technical principles of the present invention. Those skilled in the art will appreciate that the present invention is not limited to the specific embodiments described herein, and that various obvious changes, rearrangements, combinations and substitutions are possible for those skilled in the art without departing from the scope of protection of the present invention. Therefore, although the present invention is described in detail through the above embodiments, it is not merely limited to the above embodiments. Without departing from the conception of the present invention, more other equivalent embodiments may further be included, and the scope of the present invention is defined by the appended claims.

## Claims

1. A magnetic tunnel junction signal isolator with electric shielding layer, **characterized in** and composed of:
a magnetic shielding layer,
a coil,
an electric shielding layer and
a magnetoresistive sensor,
the coil is located between the magnetic shielding layer and the electric shielding layer, the electric shielding layer is located between the coil and the magnetoresistive sensor, the magnetoresistive sensor is composed of a plurality of magnetic tunnel junctions that are connected in a series-parallel way;
signal transmitting circuit: the signal transmitting circuit is electrically connected to two ends of the coil, and has a first reference ground;
signal receiving circuit: the signal receiving circuit is connected to the magnetoresistive sensor, and has a second reference ground;
the magnetic shielding layer is electrically connected to the first reference ground in a single-point or multi-point mode, or it is completely electrically isolated from the first reference ground, the electric shielding layer may instead be electrically connected to the second reference ground in a single-point or multi-point mode, or it may be completely electrically isolated from the second reference ground, or the electric shielding layer and magnetic shielding layer are respectively electrically connected to any potential or potentials between the first reference ground and the second reference ground in a single-point or multi-point mode.

2. The magnetic tunnel junction signal isolator according to claim 1 is **characterized in that** the magnetoresistive sensor is connected by a push arm and/or a pull arm to form a push-pull bridge structure for measuring a magnetic field gradient or a magnetic field value, wherein,
the push arm is composed of an interconnected array of push magnetoresistive sensor units, the array of push magnetoresistive sensor units is composed of push magnetoresistive sensor units connected in series and in parallel, the push magnetoresistive sensor unit is composed of a plurality of the magnetoresistive sensors connected in series and in parallel;
The pull arm is composed of an interconnected array of pull magnetoresistive sensor units, the array of pull magnetoresistive sensor units is composed of pull magnetoresistive sensor units connected in series and in parallel, the pull magnetoresistive sensor unit is composed of a plurality of the magnetoresistive sensors connected in series and in parallel;
The push-pull bridge structure includes any one of a push-pull half-bridge structure, a push-pull full-bridge structure, a push-pull quasi-bridge structure and a single-arm electric bridge structure.

3. The magnetic tunnel junction signal isolator according to claim 2 is **characterized in that** the angle between the magnetic field sensitive direction of the push magnetoresistive sensing unit array and the reference horizontal direction is α, and the angle between the magnetic field sensitive direction of the pull magnetoresistive sensing unit array and the reference horizontal direction is β;
the surface on one side of the coil has a first sub-region and a second sub-region, in the direction perpendicular to the coil, the push magnetoresistive sensor unit array is located in the first sub-region and the pull magnetoresistive sensor unit array is located in the second sub-region, when current flows through the first sub-region, magnetic field Bα is generated along the magnetic field sensitive direction of the push magnetoresistive sensor unit array, when current flows through the second sub-region, magnetic field Bβ is generated along the magnetic field sensitive direction of the pull magnetoresistive sensor unit array;
Bα and Bβ are equal in size, the direction of Bα is the same as the magnetic field sensitive direction of the push magnetoresistive sensor unit array, while the direction of Bβ is opposite to the magnetic field sensitive direction of the pull magnetoresistive sensor unit array, the range of α and β is 0-360°.

4. The magnetic tunnel junction signal isolator according to claim 1 is **characterized in that** the magnetoresistive sensor is a linear or a switched magnetoresistive sensor, and a plurality of magnetic tunnel junctions in the linear or switched magnetoresistive sensor are connected to form a two-port structure.

5. The magnetic tunnel junction signal isolator according to claim 1 is **characterized in that** the magnetic tunnel junction signal isolator comprises magnetic shielding pins and/or electric shielding pins, the magnetic shielding layer sets the electric potential through the magnetic shielding pins, and the electric shielding layer sets the electric potential through the electric shielding pins.

6. The magnetic tunnel junction signal isolator according to claim 1 is **characterized in that** the signal transmitting circuit is connected to the coil in a passive or active manner.

7. The magnetic tunnel junction signal isolator according to claim 1 is **characterized in that** the signal receiving circuit is connected to the magnetoresistive sensor in a passive or active manner.

8. The magnetic tunnel junction signal isolator according to claim 6 or 7 is **characterized in that**, during packaging, the dice containing the magnetic tunnel junction signal isolator are placed separately on a lead frame and then packaged with a packaging material; or
during packaging, the dice containing the magnetic tunnel junction signal isolator and the signal transmitting circuit are placed on a lead frame and then packaged with packaging materials; or,
during packaging, the dice containing the magnetic tunnel junction signal isolator and signal receiving circuit are placed on a lead frame and then packaged with packaging materials;
during packaging, the pins of the signal transmitting circuit and the pins of the signal receiving circuit on the lead frame are respectively located on two opposite sides of the lead frame;
the packaging material is any one of polymer material, ceramic material, ferromagnetic metal and non-magnetic metal.

9. The magnetic tunnel junction signal isolator according to claim 5 is **characterized in** and composed of an electric shielding potential setting circuit and/or a magnetic shielding potential setting circuit;
the electric shielding potential setting circuit ensures that the measured potential difference is equal to the set potential difference by comparing the measured potential difference between the magnetoresistive sensor and the coil with the set potential difference, and adjusting the potential size of the electric shielding layer;
the magnetic shielding potential setting circuit ensures that the measured potential difference is equal to the set potential difference by comparing the measured potential difference between the magnetoresistive sensor and the coil with the set potential difference, and adjusting the potential size of the magnetic shielding layer.

10. The magnetic tunnel junction signal isolator according to claim 1 is **characterized in that** the magnetic shielding layer, the coil, the magnetoresistive sensor and the electric shielding layer are isolated by insulating materials, and the insulating materials are Si₃N₄, Al₂O₃, photoresist, SiO₂ or polyimide.

11. The magnetic tunnel junction signal isolator according to claim 1 is **characterized in that** the coil has a thickness ranging from 1 µm to 20 µm, a width ranging from 5 µm to 40 µm, and a spacing ranging from 10 µm to 100 µm;
the thickness of the magnetic shielding layer and the electric shielding layer varies from 1µm to 20 µm.
